# EUROPEAN PATENT APPLICATION

(11) **EP 3 187 550 A1**
(43) Date of publication of application: **05.07.2017**
(21) Application number: 15835330.0
(22) Date of filing: 27.08.2015
(51) Int. Cl.: C09B 57/10, H01L 31/042

(54) **NOVEL RUTHENIUM-BASED DYE AND METHOD FOR PREPARING SAME**

(30) Priority: 28.08.2014 KR 20140113109; 26.08.2015 KR 20150120521
(71) Applicant: Dongjin Semichem Co., Ltd, Incheon 404-205 (KR)
(72) Inventor: MIN, Byung Cheol, Hwaseong-si Gyeonggi-do 18635 (KR); KIM, Seong Hoon, Hwaseong-si Gyeonggi-do 18635 (KR); KIM, Yong Joo, Hwaseong-si Gyeonggi-do 18635 (KR); KIM, Bong Gi, Hwaseong-si Gyeonggi-do 18635 (KR); KIM, Jong Bok, Hwaseong-si Gyeonggi-do 18635 (KR); KIM, Hee Joo, Hwaseong-si Gyeonggi-do 18635 (KR)
(74) Representative: Bockhorni & Kollegen
(86) International application number: PCT/KR2015/009008
(87) International publication number: WO 2016/032266

(57) **Abstract**

The present invention relates to a novel ruthenium-based dye and a method for preparing the same, and more specifically, to a bipyridine-based ruthenium dye which prevents an interaction with I₂ of an electrolyte by introducing a hydrophobic group combined with oxygen into a ligand site; exhibits an improved photoelectric conversion efficiency and long-term stability, thereby greatly improving efficiency and lifespan of a solar cell; and is synthesized by a relatively simple method, thereby reducing its manufacturing costs. The bipyridine-based ruthenium dye of the present invention is used as a dye in a dye-sensitized solar cell (DSSC) and thus has higher efficiency and better long-term stability than existing dyes, thereby significantly improving efficiency of the solar cell.

## Description

### FIELD OF THE INVENTION

The present invention relates to a novel ruthenium-based dye having high efficiency and long-term stability and a method for preparing the same.

### BACKGROUND OF THE INVENTION

Since a dye-sensitized solar cell (DSSC) has higher efficiency and significantly lower manufacturing costs than an existing silicon-based solar cell, it can possibly replace the existing amorphous silicon solar cells, and unlike the silicon solar cells, the dye-sensitized solar cell is a photo electrochemical solar cell which comprises a dye molecule absorbing visible rays to generate an electron-hole pair, and a transition metal oxide transferring the generated electron as main components.

The basic key materials of the high-efficient dye-sensitized solar cells may include a dye, an electrolyte, and a metal oxide. When these three materials are balanced with optimized conditions, efficiency of the dye-sensitized solar cells may be maximized.

In addition to the efficiency, when it comes to the dye-sensitized solar cells, a long-term stability is a very important element and accordingly, there is still need of study about dyes for manufacturing solar cells with high efficiency and long lifespan.

### SUMMARY OF THE INVENTION

Therefore, it is an object of the present invention to provide a novel dye having high efficiency and at the same time, having superior long-term stability so that it can secure the long lifespan of a dye-sensitized solar cell.

It is another object of the invention to provide a method for preparing the dye described in the above.

It is still another object of the invention to provide a superior dye-sensitized photoelectric conversion device and dye-sensitized solar cell having high efficiency and long lifespan by comprising the dye described in the above.

In order to achieve the above objects, the present invention provides a ruthenium-based dye represented by the following chemical formula 1: 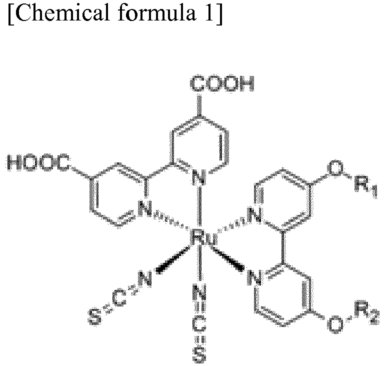 wherein R₁ and R₂ may be the same or different from each other and they are each independently alkyl having 1 to 18 carbon atoms, preferably alkyl having 6 to 10 carbon atoms, and the hydrogen of -COOH may be substituted by a monovalent metal.

In another aspect, the invention provides a method for preparing a dye of chemical formula 1 characterized by comprising the processes of the following reaction formula 1:

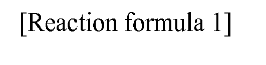

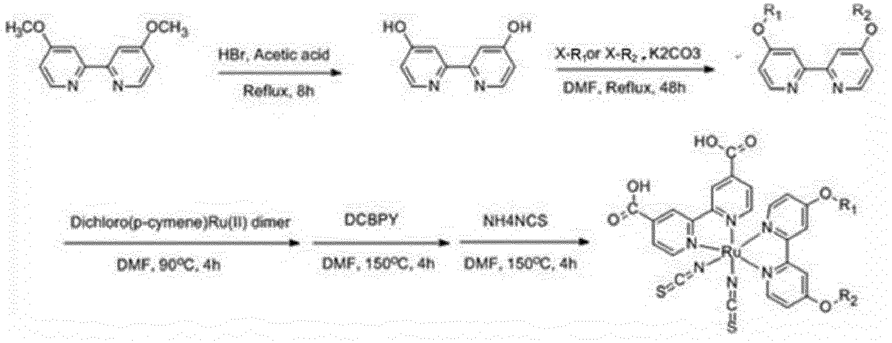

In the above reaction formula 1, X is halogen, R₁ and R₂ may be the same or different from each other and they are as defined in the above chemical formula 1, and the hydrogen of - COOH may be substituted by a monovalent metal.

In another aspect, the invention provides a dye-sensitized photoelectric conversion device characterized by comprising an oxide semiconductor particle with the above dye deposited thereon.

In still another aspect, the invention provides a dye-sensitized solar cell characterized by comprising the dye-sensitized photoelectric conversion device.

The novel ruthenium-based dye of the present invention can prevent an interaction with I₂ of an electrolyte by introducing a hydrophobic group combined with oxygen into a ligand site; it exhibits an improved photoelectric conversion efficiency and long-term stability, thereby greatly improving efficiency and lifespan of a solar cell; and it can be synthesized by a relatively simple method, thereby reducing its manufacturing costs.

In addition, the dye-sensitized photoelectric conversion device and solar cell using the dye of the present invention exhibit superior solar cell efficiency, have a long lifespan, facilitate the manufacturing of solar cell devices, and can reduce the manufacturing costs of solar cells, even with the use of a relatively very small amount of the dye and oxide semiconductor particle by using the novel dye having an improved photoelectric conversion efficiency and long term stability.

### DETAILED DESCRIPTION OF THE INVENTION

Hereafter, the present invention will be described in detail.

The ruthenium-based dye of the present invention is characterized by being represented by the following chemical formula 1.

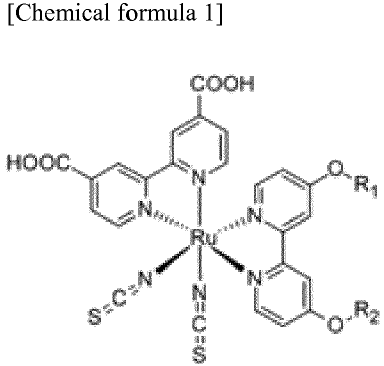

In the above chemical formula, R₁ and R₂ may be the same or different from each other and they are each independently alkyl having 1 to 18 carbon atoms, and the hydrogen of - COOH may be substituted by a monovalent metal. Preferably, R₁ and R₂ may be each independently alkyl having 6 to 10 carbon atoms, and in this case, it can promote high efficiency and long lifespan of solar cells, and in particular, when R₁ and R₂ are the same, it is more advantageous in terms of the high efficiency and long lifespan of the solar cells.

Preferably, the dye may be one of the dyes represented by the following chemical formulae.

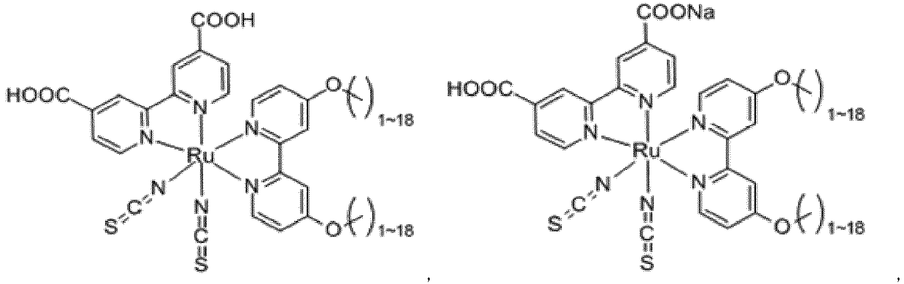

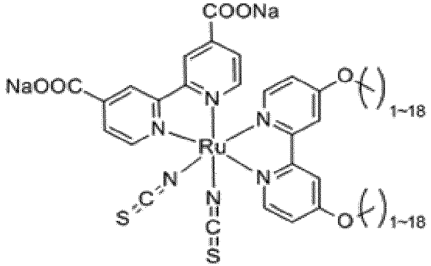

More particularly, the dye of the present invention may be one of the dyes of the following chemical formulae. In the following chemical formulae, the hydrogen of -COOH may be substituted by a monovalent metal.

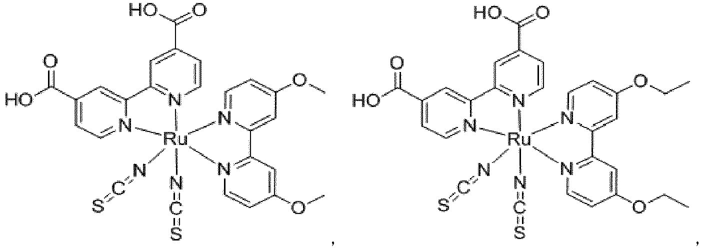

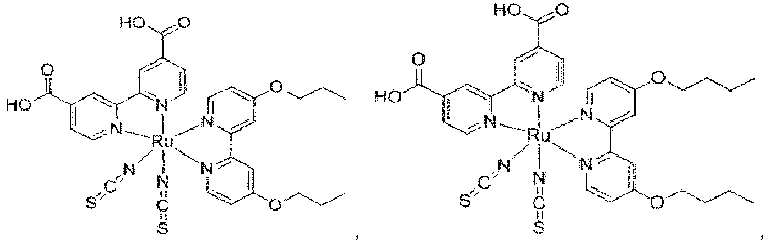

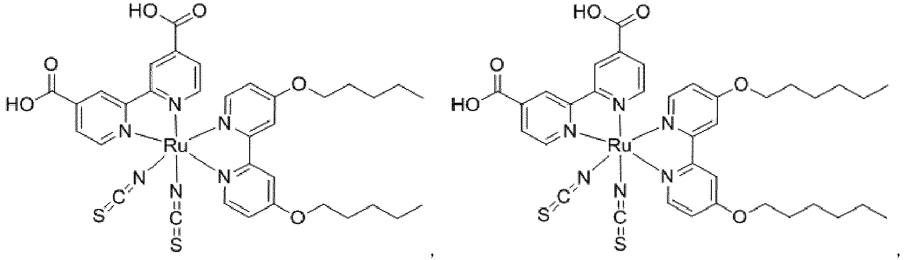

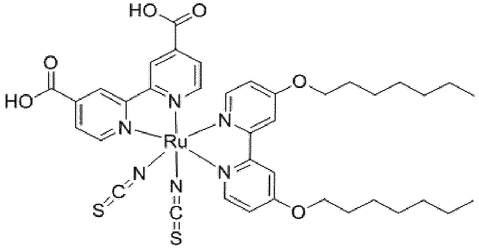

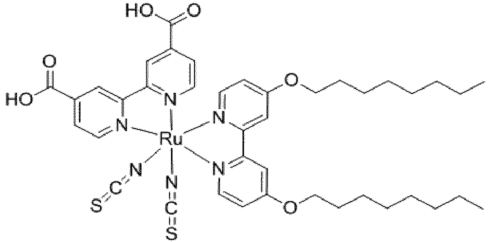

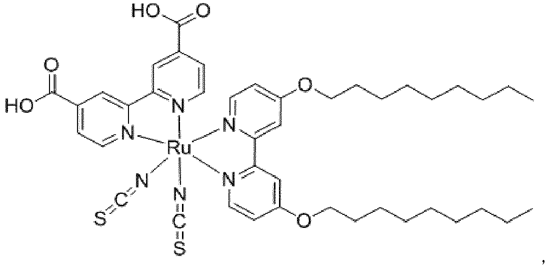

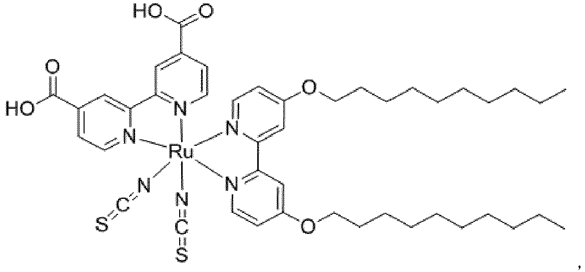

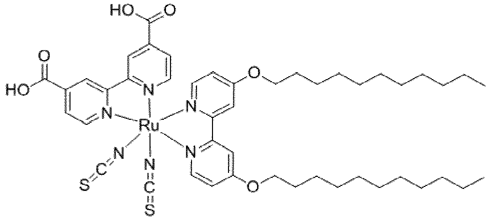

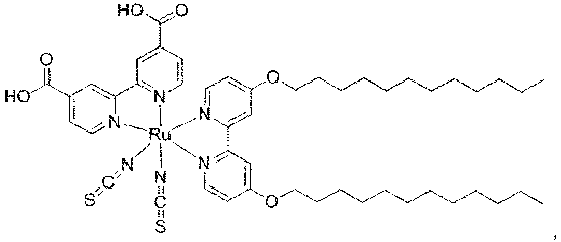

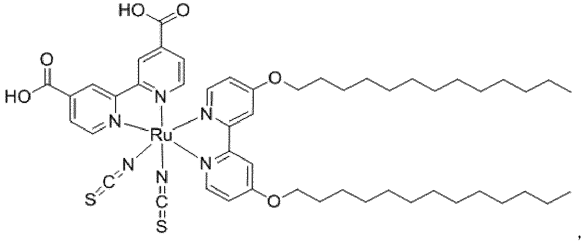

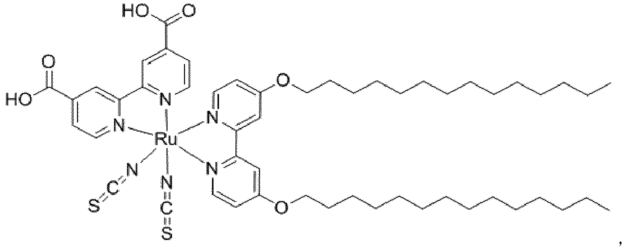

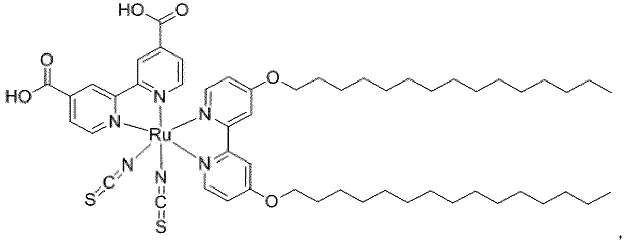

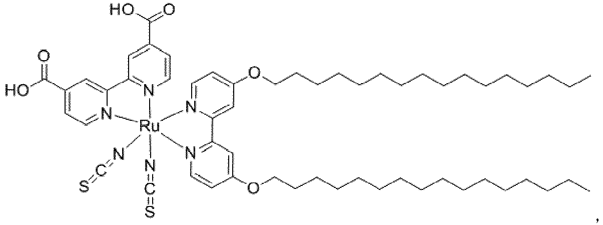

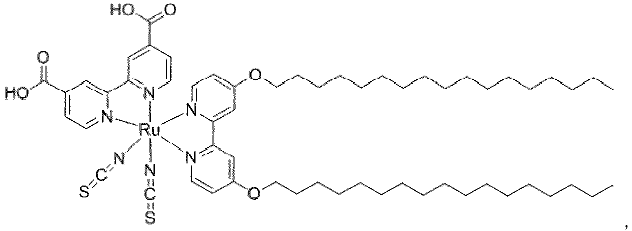

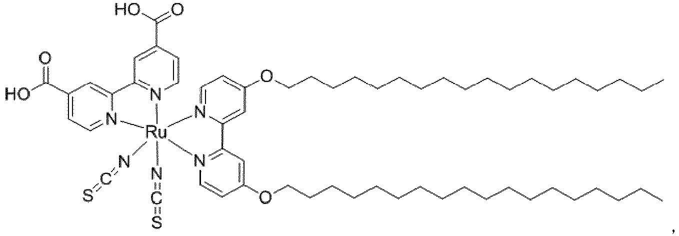

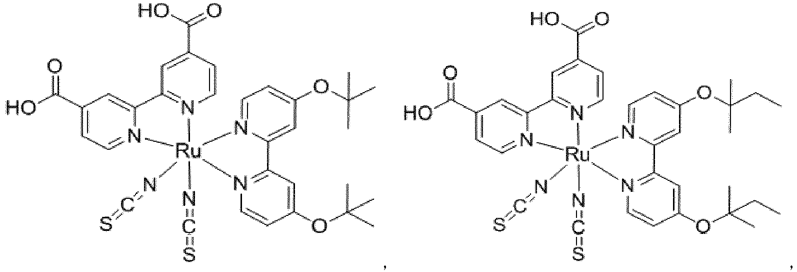

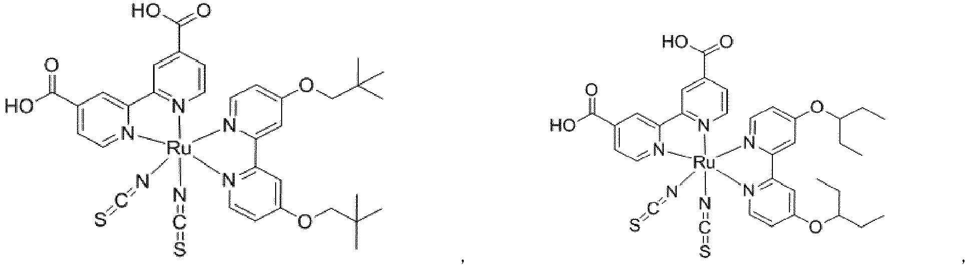

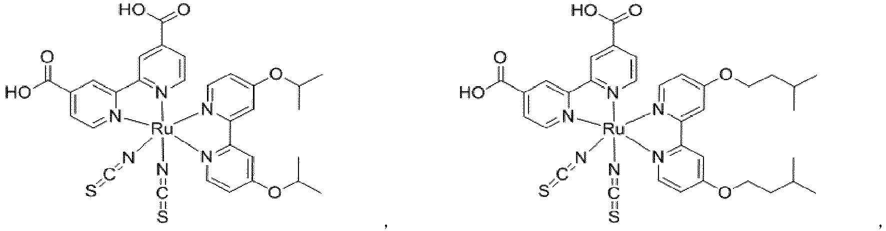

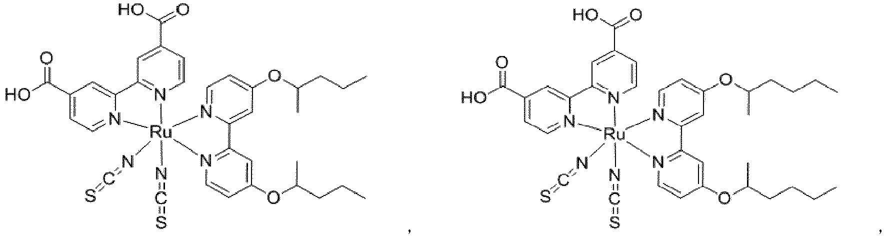

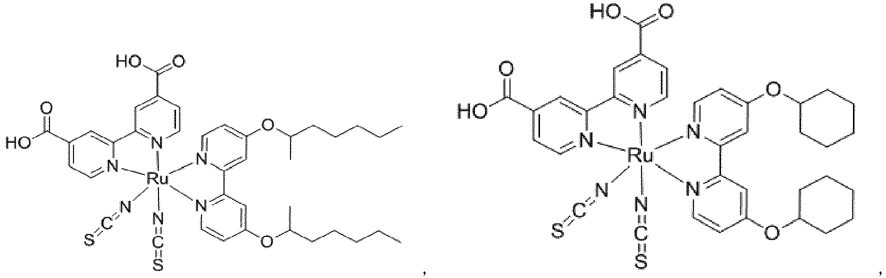

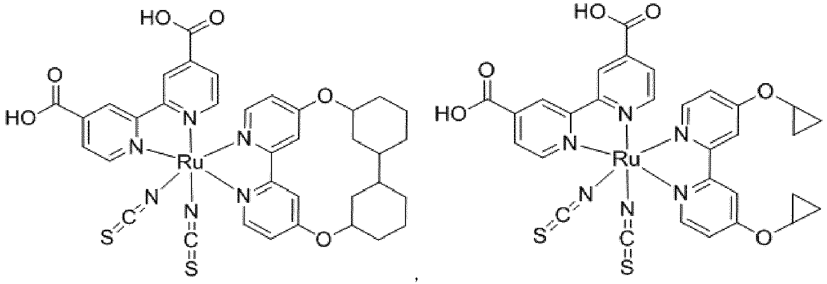

The dye of the present invention can secure superior long-term stability over 1000 hours in comparison with existing commercial dyes by introducing a hydrophobic alkyl chain combined with oxygen into a ligand site. Further, the dye of the invention contains oxygen, which prevents an interaction between the existing sulfur group and I₂ of an electrolyte from lowering open circuit voltage value and thus reducing efficiency, and can secure long-term stability of the dye.

In another aspect, the dye of the chemical formula 1 in accordance with the present invention can be prepared through the processes of the following reaction formula 1.

### [Reaction formula 1]

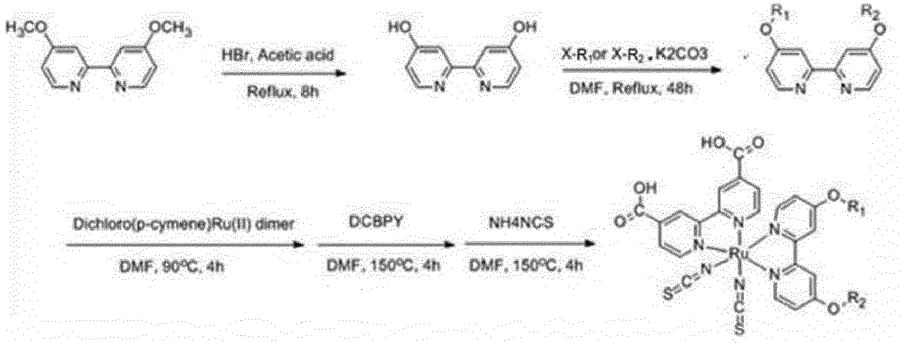

In the above reaction formula 1, X is halogen, R₁ and R₂ may be the same or different and they are as defined in the above chemical formula 1, and the hydrogen of -COOH may be substituted by a monovalent metal. In particular, when R₁ and R₂ are the same, it is more advantageous in terms of the high efficiency and long lifespan of the solar cells.

As a specific embodiment, the preparation method may be as shown in the following reaction formula 2.

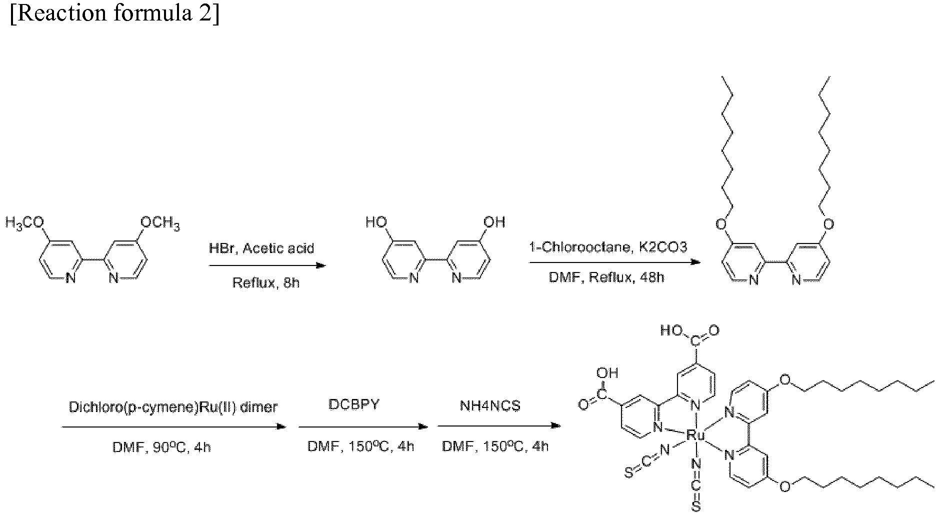

The compound of chemical formula 1 prepared by the method according to the present invention can be purified by the dye purification methods commonly used in the pertinent art.

In another aspect, the present invention provides a dye-sensitized photoelectric conversion device, and the dye-sensitized photoelectric conversion device is characterized by depositing the dye represented by the above chemial formula 1 according to the invention on an oxide semiconductor particle. It is noted that with the exception that the dye according to the present invention is used, any methods for preparaing dye-sensitized photoelectric conversion devices for solar cells using the existing dyes can be applied, for example, the methods described in Korea Patent Laid-Open Publication No. 10-2009-38377 (filed by Dongjin Semichem Co., Ltd.) can be applied, and preferably, the dye-sensitized photoelectric conversion device of the present invention may be obtained by preparing a thin film of oxide semiconductor on a substrate using an oxide semicouductor particle and then depositing the dye of the invention on the thin film.

In another aspect, the present invention provides a dye-sensitized solar cell characterized by comprising the dye-sensitized photoelectric conversion device, it is noted that with the exception that the dye-sensitized photoelectric conversion device using the oxide semiconductor particle with the dye represented by the above chemial formula 1 deposited thereon is used, any ordinary methods for preparing solar cells using the exising photoelectric conversion devices can be applied, for example, the methods described in Korea Patent Laid-Open Publication No. 10-2009-38377 (filed by Dongjin Semichem Co., Ltd.) can be applied, and preferably, it can be comprised of the photoelectric conversion device electrode (negative electrode) comprising the oxide semiconductor particle with the dye represented by chemical formula 1 deposited thereon, a counter electrode (positive electrode), a redox electrolyte, a hole transport material or a p-type semiconductor, etc. More particularly, it may comprise the dye-sensitized photoelectrode comprising a photo electrode layer with the dye represented by the above chemical formula 1 of the present invention absorbed thereon; a catalyst electrode countering the photoelectrode; an electrolyte electrically connecting the photoelectrode and the catalyst electrode; and a sealing part sealing the photoelectrode, the catalyst electrode and the electrolyte as a top plate, a bottome plate and an encapsulating material.

The dye-sensitized solar cell in accordance with the present invention has superior long-term stability and efficiency, and in particular, even after the curing of 1056 hours, it exhibits efficiency reduction of less than 7% compared to the initial efficiency, and it can exhibit efficiency of at least 3.78%.

The present invention will be explained in more detail with reference to the following examples. However, the examples are only to illustrate the present invention and the scope of the present invention is not limited thereto.

### EXAMPLES

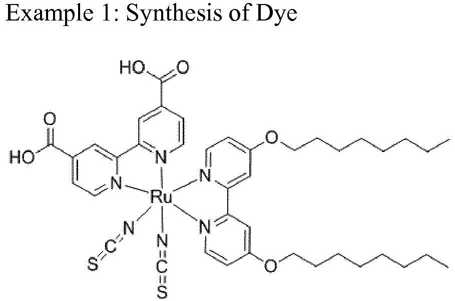

A dye was prepared according to the reaction formula 2 described in the above.

Specifically, 4,4'-dimethoxy-2,2'-bipyridine and HBr were refluxed with glacial acetic acid solvent for 6-10 hours. After the completion of the reaction, the product was neutralized using ammonia water. The neutralized product and K₂CO₃ were stired with DMF solvent. After the addition of 1-chlorooctane, the product was refluxed for 40-50 hours. Thereafter, the product was recrystalized using methanol. The product and dichloro(p-cymene)Ru(II) dimer were refluxed with DMF solvent at 70-100 °C for 3-6 hours. After that, the reaction temperature was increased to 130-170 °C and then, the product was refluxed for 3-6 hours after the addition of 2,2'-bipyridyl-4,4'-dicarboxylic acid. After the reflux, ammonium thiocyanate was added to the product, which was then refluxed for 3-6 hours and purified via sephadex column and pH titration to yield a dye.

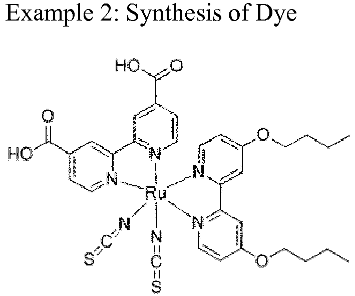

The above dye was prepared by applying the method of Example 1 so that R₁ and R₂ in chemical formula 1 could be the same as in the above chemical formula.

### Example 3: Synthesis of Dye

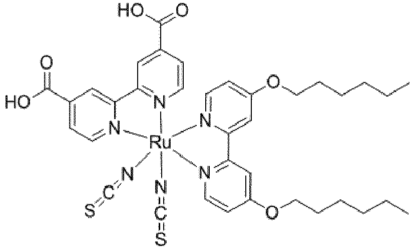

The above dye was prepared by applying the method of Example 1 so that R₁ and R₂ in chemical formula 1 could be the same as in the above chemical formula.

### Example 4: Synthesis of Dye

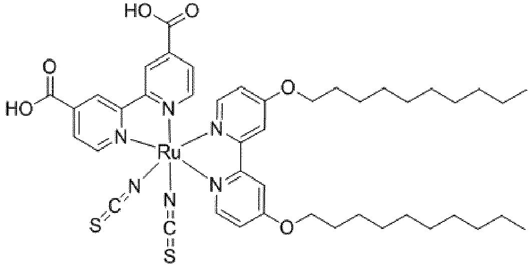

The above dye was prepared by applying the method of Example 1 so that R₁ and R₂ in chemical formula 1 could be the same as in the above chemical formula.

### Example 5: Synthesis of Dye

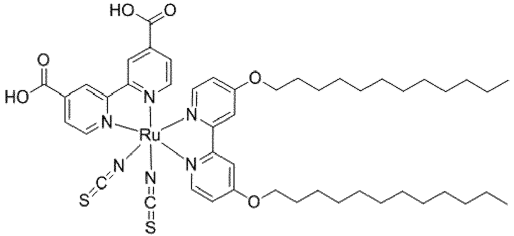

The above dye was prepared by applying the method of Example 1 so that R₁ and R₂ in chemical formula 1 could be the same as in the above chemical formula.

### Example 6: Synthesis of Dye

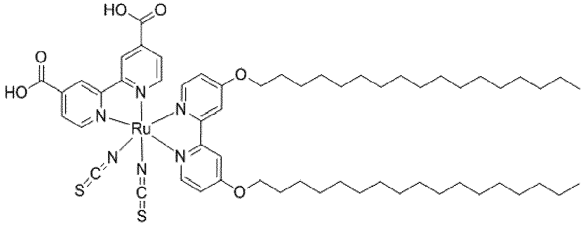

The above dye was prepared by applying the method of Example 1 so that R₁ and R₂ in chemical formula 1 could be the same as in the above chemical formula.

### Example 7: Synthesis of Dye

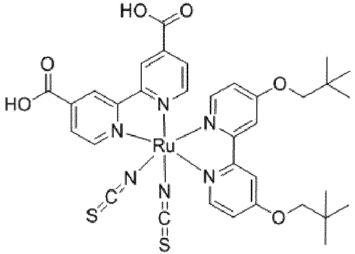

The above dye was prepared by applying the method of Example 1 so that R₁ and R₂ in chemical formula 1 could be the same as in the above chemical formula.

### Example 8: Synthesis of Dye

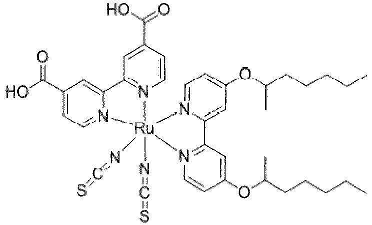

The above dye was prepared by applying the method of Example 1 so that R₁ and R₂ in chemical formula 1 could be the same as in the above chemical formula.

### Example 9: Synthesis of Dye

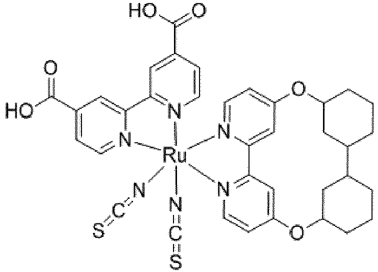

The above dye was prepared by applying the method of Example 1 so that R₁ and R₂ in chemical formula 1 could be the same as in the above chemical formula.

### Example 10: Synthesis of Dye

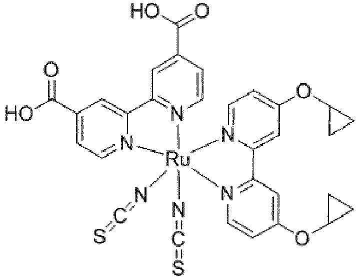

The above dye was prepared by applying the method of Example 1 so that R₁ and R₂ in chemical formula 1 could be the same as in the above chemical formula.

### Examples 11 to Examples 20: Preparation of Solar Cell

DTY4 photoelectrode paste (12 *µ*m, Dongjin Semichem, Korea) and DSL3 scattering paste (4 *µ*m, Dongjin Semichem, Korea) were coated on an FTO glass using doctor blade method. The paste on the photoelectrode was sintered at 450 °C for 30 min. to form a TiO₂ thin film layer having the thickness of 17 *µ*m.

The dyes prepared in the above Examples 1 to 10 were each dissolved at the concentration of 0.5 mM in a solvent where acetonitrile and t-butylalcohol were mixed in a volume ratio of 1:1 to prepare dye solutions and then, the sintered thin film layers were dipped in the dye solutions at a room temperature for 18 hours. After that, solar cells were prepared according to common solar cell preparation methods.

As the redox electrolyte solution used in the above solar cells, a solution obtained by dissolving 1.0M 1,3-dimethyl imidazolium iode, 30 mM iodine, 50 mM LiI, 0.1 M guanidinium thiocynate, and 0.5M t-butylpyridine in a solvent where valeronitrile and acetonitrile were mixed in a volume ratio of 15:85 was used.

### Comparative Example 1: Preparation of Solar Cell

With the exception that the dye of the following structure was used as a dye, a solar cell was prepared by the same method as above Examples 11.

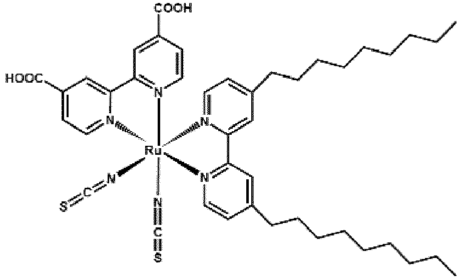

### Comparative Example 2: Preparation of Solar Cell

With the exception that the dye of the following structure was used as a dye, a solar cell was prepared by the same method as above Examples 11.

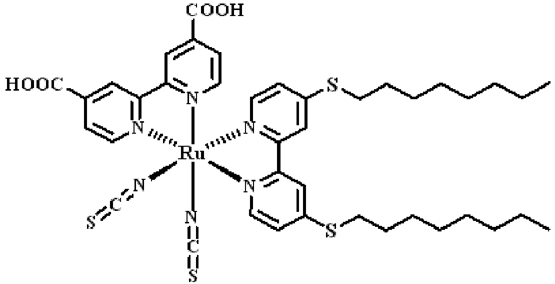

η(%) of the dye-sensitized solar cells prepared using the dyes, which were prepared in above Examples 11 to 20 and Comparative Examples 1 to 2, were measured using Keithley M 236 source measure unit, with 300 W Xe lamp equipped with AM 1.5 filter (Oriel) as a light source, electrode size of 0.4 × 0.4 cm², and light intensity of 1 sun (100 mW/cm²). Light intensity was controlled using Si solar cell. The results are shown in the following Table 1. Efficiency measurement was performed immediately after the preparation and after heat treatment for 24 hours, 720 hours, and 1056 hours in 85 °C oven, respectively.

**[Table 1]**

| | Initial Efficiency η(%) | Efficiency After 24 Hours η(%) | Efficiency After 720 Hours η(%) | Efficiency After 1056 Hours η(%) | Efficiency Reduction Rate After 1056 Hours (%) |
|---|---|---|---|---|---|
| Com. Ex 1 | 4.24 | 4.16 | 3.80 | 3.65 | 14 |
| Com. Ex. 2 | 4.23 | 4.13 | 3.83 | 3.55 | 16 |
| Ex. 11 | 4.32 | 4.30 | 4.20 | 4.17 | 3.5 |
| Ex. 12 | 4.21 | 4.18 | 4.11 | 4.01 | 4.8 |
| Ex. 13 | 4.18 | 4.11 | 4.05 | 4.03 | 3.6 |
| Ex. 14 | 4.24 | 4.19 | 4.17 | 4.11 | 3.1 |
| Ex. 15 | 4.18 | 4.14 | 4.09 | 4.00 | 4.3 |
| Ex. 16 | 4.15 | 4.10 | 4.03 | 3.96 | 4.6 |
| Ex. 17 | 4.19 | 4.19 | 4.11 | 4.02 | 4.1 |
| Ex. 18 | 4.20 | 4.15 | 4.11 | 4.06 | 3.3 |
| Ex. 19 | 4.02 | 3.93 | 3.91 | 3.88 | 3.5 |
| Ex. 20 | 4.05 | 4.01 | 3.88 | 3.78 | 6.7 |

As shown in the above Table 1, Comparative Example 1 and Comparative Example 2 exhibited efficiency reduction of 14% and 16%, respectively, after a lapse of 1056 hours.

On the contrary, Examples 11 to 20 of the present invention exhibited 3.88% or more efficiencies after 720-hour curing and 3.78% or more after a lapse of 1056 hours, and they exhibited efficiency reduction of less than 7% compared to the initial efficiency, confirming superior efficiency and long-term stability even after a long-time curing. In particular, when R₁ and R₂ in chemical formula 1 are the same and carbon atoms are 6 to 10 (Examples 11, 13, 14, 18, and 19), more excellent long-term stability could be obtained.

## Claims

1. A ruthenium-based dye represented by the following chemical formula 1: 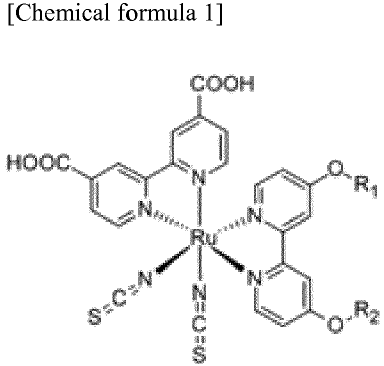 wherein R₁ and R₂ may be the same or different from each other, and they are each independently alkyl having 1 to 18 carbon atoms, preferably alkyl having 6 to 10 carbon atoms, and the hydrogen of -COOH may be substituted by a monovalent metal.

2. The ruthenium-based dye of Claim 1, wherein R₁ and R₂ are the same.

3. The ruthenium-based dye of Claim 1 or Claim 2, wherein R₁ and R₂ are alkyl having 6 to 10 carbon atoms.

4. The ruthenium-based dye of Claim 1, wherein the dye is represented by any one of the following formulae:

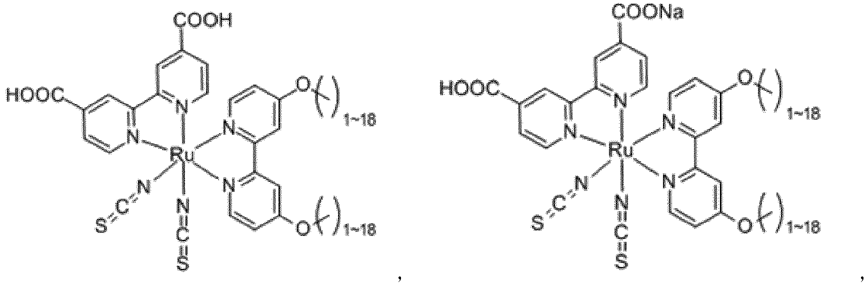

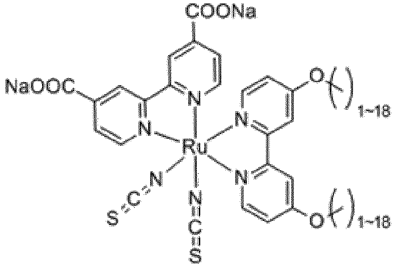

5. The ruthenium-based dye of Claim 1, wherein the dye is represented by any one of the following formulae: 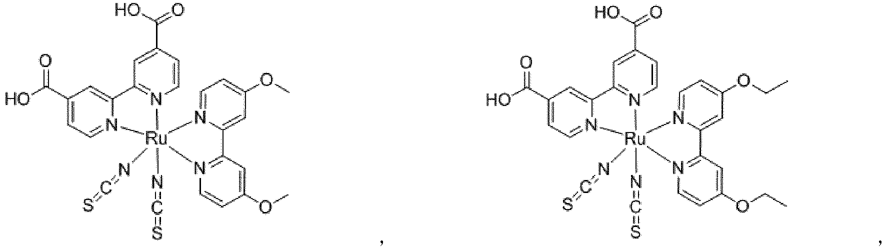 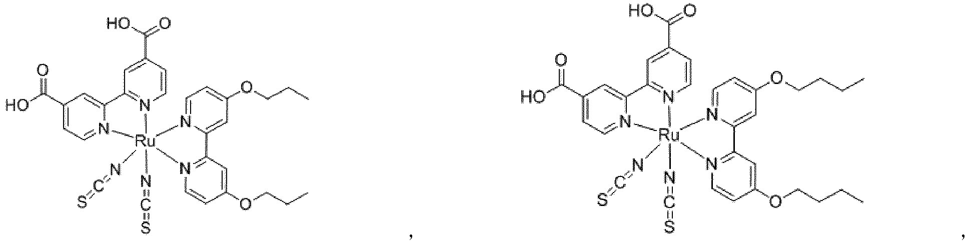 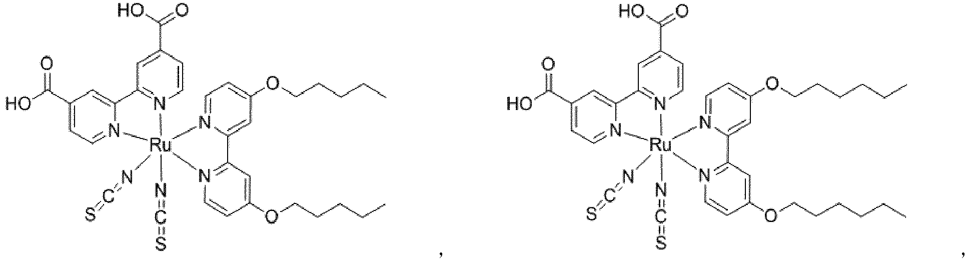 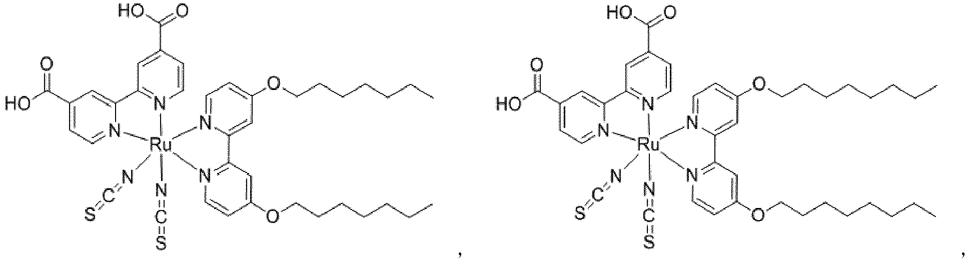 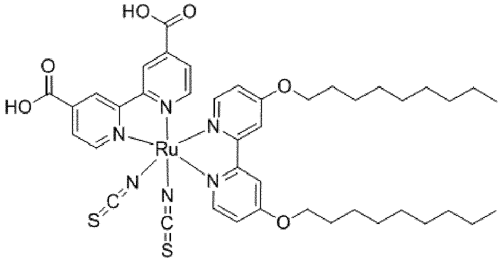 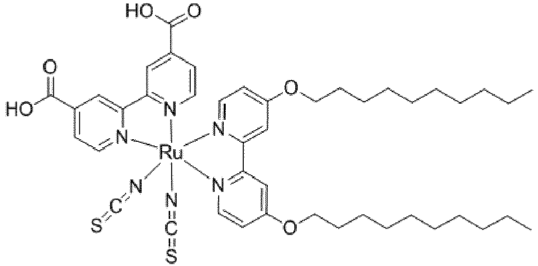 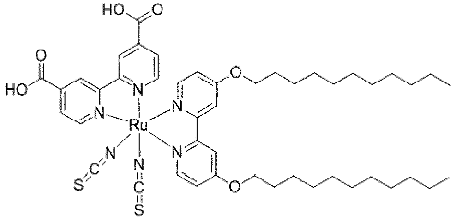 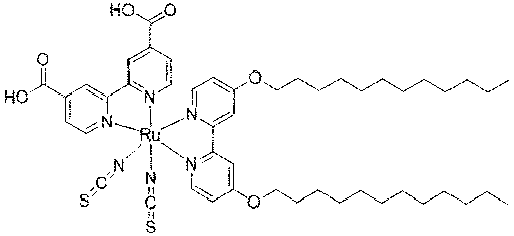 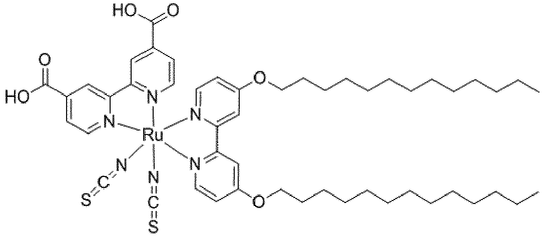 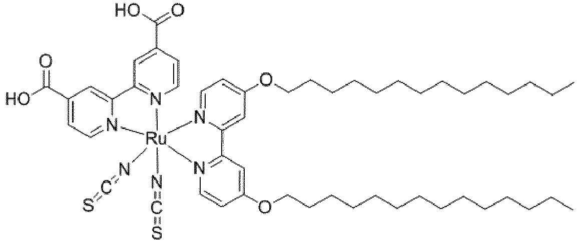 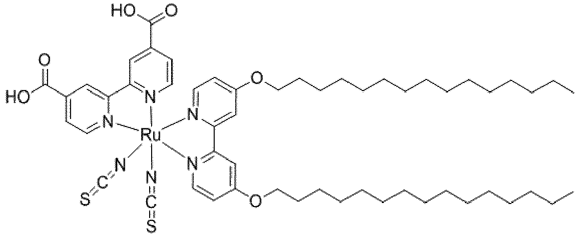 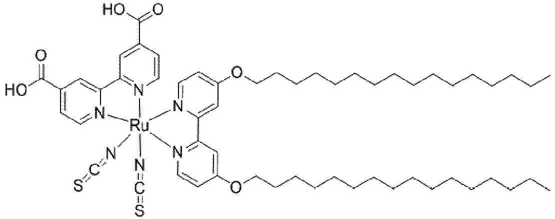 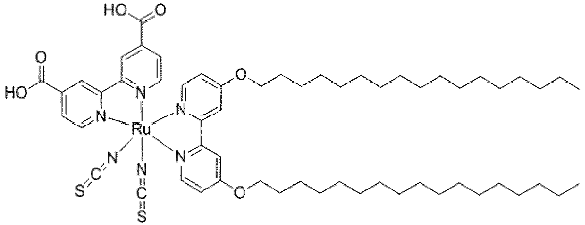 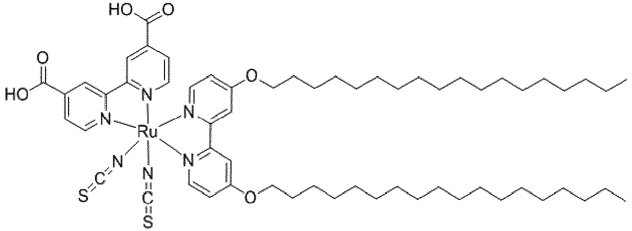 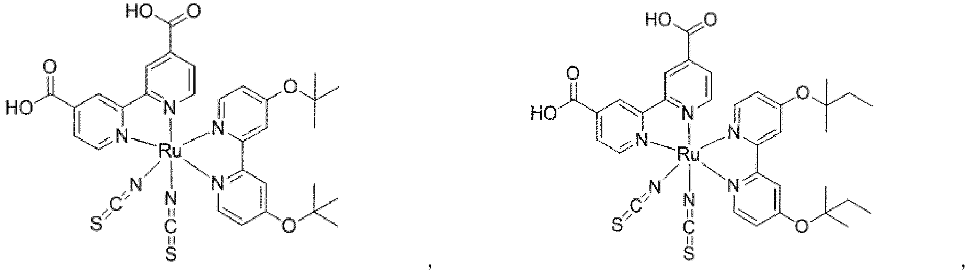 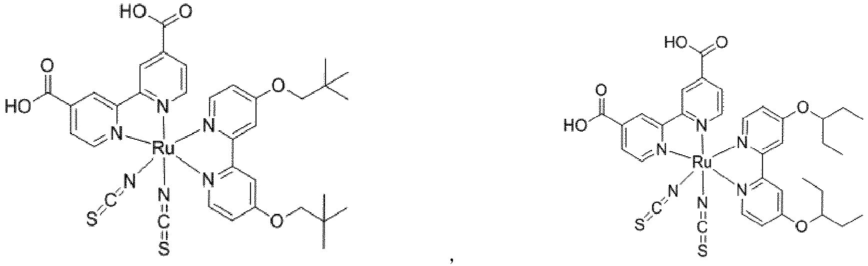 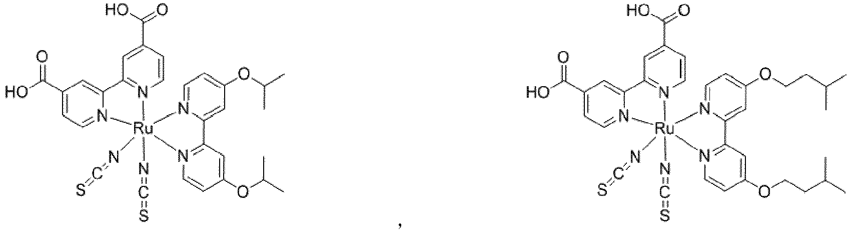 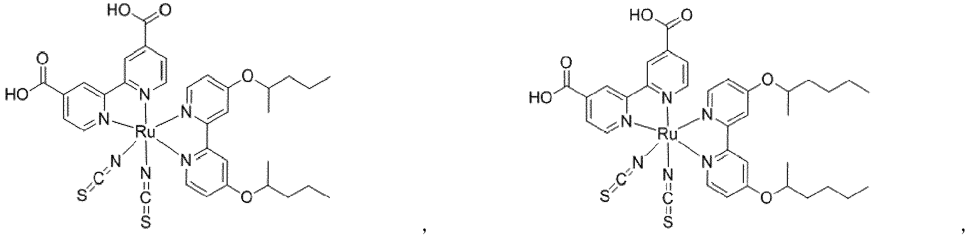 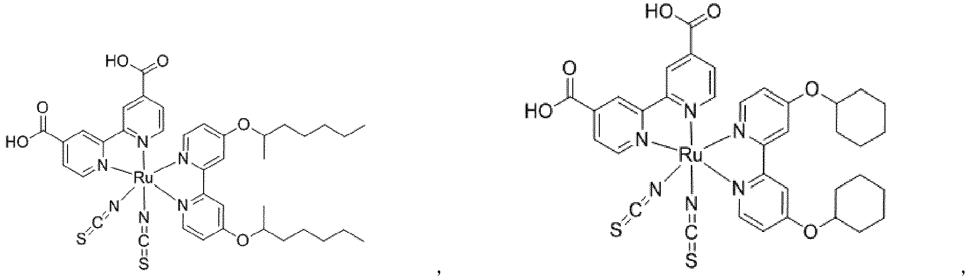 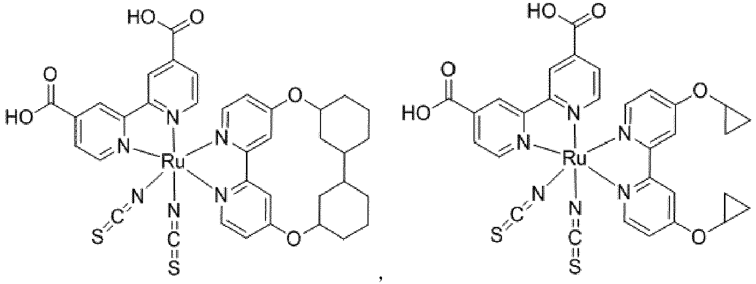 wherein the hydrogen of -COOH may be substituted by a monovalent metal.

6. A dye-sensitized solar cell comprising a photoelectrode comprising a photoelectrode layer with the dye described in Claim 1 abosrbed thereon;
a catalyst electrode countering the photoelectrode;
an electrolyte electrically connecting the photoelectrode and the catalyst electrode; and
a sealing part sealing the photoelectrode, the catalyst electrode and the electrolyte as a top plate, a bottom plate and an encapsulating material.

7. The dye-sensitized solar cell of Claim 6, wherein the dye-sensitized solar cell exhibits efficiency reduction of less than 7% compared to the initial efficiency after 1056-hour curing.

8. The dye-sensitized solar cell of Claim 6, wherein the dye-sensitized solar cell exhibits efficiency of at least 3.78% after 1056-hour curing.
